# EUROPÄISCHE PATENTANMELDUNG

(11) **EP 0 651 445 A2**
(43) Veröffentlichungstag der Anmeldung: **03.05.1995**
(21) Anmeldenummer: 94115817.2
(22) Anmeldetag: 07.10.1994
(51) Int. Cl.: H01L 29/74

(54) **Abschaltbarer Thyristor**

(30) Priorität: 30.10.1993 DE 4337209
(71) Anmelder: ABB Management AG, CH-5401 Baden (CH)
(72) Erfinder: Bauer, Friedhelm, Dr., CH-3063 Ittigen (CH); Streit, Peter, Dr., CH-8967 Widen (CH)

(57) **Zusammenfassung**

Es wird ein GTO mit einem Kathodenemitter (7) angegeben, welcher Kathodenemitter eine schwache Emissionseffizienz aufweist. Durch diesen Kathodenemitter (7) erhält man eine deutlich erhöhte Resistenz gegen Ausbildung von Stromfilamenten. Dadurch können höhere Abschaltstromdichten sicher beherrscht werden. Zudem beträgt der Anteil des Löcherstroms am Gesamtstrom mehr als 10%. Dies wir z.B. dadurch erreicht, dass die Eindringtiefe < 1µm und die Randkonzentration < 10¹⁹cm⁻³ gewählt wird.

## Beschreibung

### Technisches Gebiet

Die Erfindung bezieht sich auf das Gebiet der Leistungshalbleiterbauelemente.

Sie geht aus von einem abschaltbaren Leistungshalbleiterbauelement nach dem Oberbegriff des ersten Anspruchs.

### Stand der Technik

Ein solches abschaltbares Leistungshalbleiterbauelement ist wohl bekannt und wird beispielsweise im Artikel "GTO Thyristors" von Makoto Azuma et al. (Proceedings of the IEEE, Vol. 76, No. 4, April 1988) beschrieben.

Abschaltbare Leistungshalbleiterbauelemente dieses Typs sind aus einer Vielzahl von Einheitszellen zusammengesetzt und weisen zwischen zwei Hauptflächen eine Anzahl von unterschiedlich dotierten Schichten auf. Von der Anode her folgen auf einen z.B. p-dotierten Anodenemitter eine n-Basis und eine p-Basis. In die p-Basis sind n-dotierte Kathodenemittergebiete eingelassen. Selbstverständlich können die Schichten auch umgekehrt dotiert sein. Solche Bauelemente sind auch unter dem Namen GTO (Gate Turn Off Thyristor) bekannt.

Bei diesen ist die Eindringtiefe der Kathodenemittergebiete in Richtung der Anode so gewählt, dass eine maximale Emittereffizienz resultiert. Dies wird konstruktiv bei den heutigen GTOs dadurch erreicht, dass der Kathodenemitter eine Randkonzentration von 10²⁰cm⁻³ und eine Tiefe des pn-Übergangs von etwa 10 µm aufweist. Dadurch erreicht man, dass der Anteil des Minoritätsträgerstroms im Emitter normalerweise unter 1% liegt. Wegen der hohen Emittereffizienz ist der Raum unterhalb des Emitters mit einer sehr hohen Plasmadichte gefüllt, was für die geforderten, niedrigen Durchlassverluste sorgt. Die hohe Plasmadichte neigt aber zu Instabilität insbesondere beim Abschalten. Die Folgen für die heutigen GTOs sind bekannt: beschränktes Abschaltvermögen sowie Stromfilamentierung. Um den Einfluss dieser Nachteile einzuschränken, werden deshalb im GTO lebensdauerbeschränkende Massnahmen wie Bestrahlung und Erzeugung von Rekombinationszentren vorgenommen. Ausserdem versieht man die Anoden der GTOs mit starken Anodenkurzschlüssen für eine möglichst schnelle Extraktion des Plasmas beim Abschalten. Diese Massnahme wie auch die Erzeugung von Rekombinationszentren verschlechtert aber den Durchlass des Bauelementes erheblich. Damit ist die heutige Dimensionierungsphilosophie in sich widersprüchlich.

Bereits heute, aber noch in vermehrtem Masse in zukünftigen Anwendungen, wird von den Leistungshalbleiterbauelementen eine hohe Strom- und Spannungsbelastbarkeit gefordert. Hier sind den heutigen, bekannten GTOs durch die erwähnten Nachteile Grenzen gesetzt, denn sie können insbesondere durch zu hohe örtliche Belastungen infolge von Stromfilamentierung zerstört werden. Um diese Zerstörung zu vermeiden, müssen die heutigen GTOs mit einer umfangreichen Schutzbeschaltung betrieben werden.

### Darstellung der Erfindung

Aufgabe der vorliegenden Erfindung ist es deshalb, ein abschaltbares Leistungshalbleiterbauelement anzugeben, welches unter Beibehaltung kleiner Durchlass- und Abschaltverluste ein wesentlich verbessertes Abschaltvermögen, d.h. höhere, abschaltbare Stromdichten bei hohen Spannungen und damit auch eine wesentliche Reduktion bzw. Eliminierung der Schutzbeschaltung aufweist. Das verbesserte Abschaltvermögen schlägt sich dabei auch in einer Vereinfachung und Verkleinerung der Ansteuereinheiten nieder.

Diese Aufgabe wird bei einem abschaltbaren Leistungshalbleiterbauelement der eingangs genannten Art durch die Merkmale des ersten Anspruchs gelöst.

Kern der Erfindung ist es also, den Kathodenemitter eines GTOs konstruktiv so zu gestalten, dass die Instabilität infolge von Stromfilamentierung weitgehend unterbunden wird. Abweichend von der bekannten Lösung, die laterale Ausdehnung der Emitterfinger zu verringern, wird der Kathodenemitter so ausgeführt, dass er eine schwache Emittereffizienz aufweist. Dadurch wird mehr als 10% des Gesamtstromes im Kathodenemitter von den Minoritätsträgern getragen. Die beschriebene Kombination von Emitterdotierungsprofil und Emittermetallisierung führt bei hohen, für Stromfilamente typischen Stromdichten zu einer drastischen Verschlechterung der Emittereffizienz. Die Reduktion der Emittereffizienz bei Betriebsstromdichte ist jedoch vernachlässigbar klein, so dass der Durchlass nicht verschlechtert wird.

Mit der beschriebenen Eigenschaft des Kathodenemitters wird der in der Struktur mögliche Grad an Stromdichteinhomogenität effizient begrenzt, so dass Stromfilamente nicht mehr zu einer lokalen Überlastung des Bauelementes führen. Diese erhöhte Stabilität wirkt sich nicht nur in einer Erhöhung der Abschaltströme, sondern auch in einer Verkleinerung der Komponenten der Schutzbeschaltung positiv aus.

Wendet man den Kern der Erfindung ebenfalls auf die Anodenseite des Bauelementes an, so kann bei unverändertem Sperrvermögen auch die Dicke reduziert werden. Dadurch können die Abschaltverluste drastisch verringert werden. Versuche haben ergeben, dass die Abschaltverluste bei fester Stromdichte nicht mehr quadratisch - wie beim Stand der Technik -, sondern nur noch linear mit der Spannung zunehmen.

Ein erstes Ausführungsbeispiel zeichnet sich dadurch aus, dass die erfindungsgemässen Kathodenemittergebiete mit sättigender Injektion bei hohen Stromdichten an ihrem Rand von einem dickeren Emitterteil nach dem Stand der Technik umgeben sind. Dadurch erhält man verbesserte Zündeigenschaften.

In einem weiteren Ausführungsbeispiel sind die Kathodenemittergebiete mit entgegengesetzt dotierten Inseln durchsetzt. Mit diesen entgegengesetzt dotierten Inseln erreicht man den selben positiven Effekt der sättigenden Injektion mit zunehmender Stromdichte. Dieses Ausführungsbeispiel erlaubt, die Tiefe der Kathodenemittergebiete zu vergrössern. Dies hat vor allem prozesstechnische Vorteile.

Bei allen Konzepten können auf der anodenseitigen Hauptfläche Anodenkurzschlüsse vorgesehen werden. Ebenso können diese Kurzschlüsse mit einer anodenseitigen Stopschicht kombiniert werden. Weiterhin können alle Konzepte mit anodenseitiger Stopschicht und einem Anodenemitter mit schwacher Emissionseffizienz ausgeführt werden.

Weitere Ausführungsbeispiele ergeben sich aus den Unteransprüchen.

Mit der Erfindung steht also ein abschaltbares Leistungshalbleiterbauelement zur Verfügung, mit welchem hohe Ströme und Spannungen problemlos und ohne Stromfilamentierung beherrscht werden können. Dadurch kann der Aufwand an Schutzbeschaltungsbauteilen verringert werden. Zudem weist das erfindungsgemässe Leistungshalbleiterbauteil kleinere Abschaltverluste auf.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Ausschnitt eines erfindungsgemässen Leistungshalbleiterbauelementes im Schnitt;
- **Fig. 2**: Eine Variante des erfindungsgemässen Leistungshalbleiterbauelements;
- **Fig. 3a-b**: Weitere Kathodenvarianten des erfindungsgemässen Leistungshalbleiterbauelements;
- **Fig. 4a-b**: Zwei Varianten von Anodenstrukturen des erfindungsgemässen Leistungshalbleiterbauelements; sowie
- **Fig. 5a-c**: Weitere Varianten von Anodenstrukturen.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

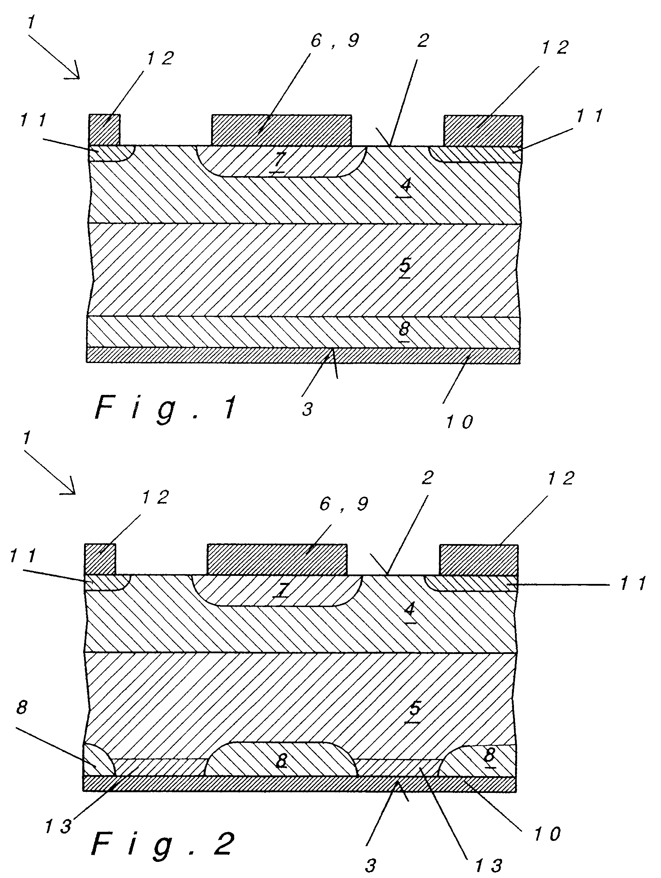

**Figur 1** zeigt einen Ausschnitt eines erfindungsgemässen Leistungshalbleiterbauelements (1) im Schnitt. Zwischen zwei Hauptflächen (2, 3) ist eine Anzahl unterschiedlich dotierter Schichten angeordnet. Von der kathodenseitigen Hauptfläche (2) folgen aufeinander eine p-Basis (4), eine n-Basis (5) sowie ein p-Anodenemitter (8). Die Anode wird durch den Anodenemitter (8) gebildet, welcher auf der anodenseitigen Hauptfläche (3) mit einer Anodenmetallisierung (10) bedeckt ist. Die Kathode (6) wird durch in die p-Basis (4) eingelassene, n+ dotierte Kathodenemittergebiete (7) gebildet, welche mit einer Kathodenmetallisierung (6) abgedeckt sind. Um das Bauelement ein- und ausschalten zu können, sind zudem p+ dotierte Gategebiete (11) vorgesehen, welche mit einer Gatemetallisierung (12) bedeckt sind und zusammen eine Gateelektrode bilden.

Die obigen Ausführungen beschrieben bis jetzt einen konventionellen Gate-Abschalt-Thyristor (GTO). Im Gegensatz zu den konventionellen GTOs, welche auf eine maximale Emittereffizienz ausgelegt sind, wodurch aber die oben beschriebenen Nachteile eingehandelt werden und weshalb sie in ihrem Einsatz beschränkt sind, wird bei der Erfindung von einem ganz anderen Ansatz ausgegangen:

Anstatt den Kathodenemitter (7) auf höchste Effizienz auszulegen, wird er so gestaltet, dass ein mit ansteigendem Gesamtstrom wachsender Anteil des Löcherstroms den Kathodenemitter rekombinationslos durchdringt. Mit ansteigendem Gesamtstrom stagniert also die Emission von Elektronen, so dass der Gesamtstrom erheblich schwächer mit der Vorwärtsspannung ansteigt als im Fall eines konventionellen, auf höchste Effizienz ausgelegten Emitters. Diese Eigenschaft des Emitters wird z.B. dadurch erreicht, dass die n-dotierte Zone eine Eindringtiefe in der Grössenordnung von Bruchteilen von µm, höchstens aber von 2 µm aufweist. Mit einem derartigen Emitterprofil gelingt es, die Rekombination der Minoritätsträger - in diesem Fall der Löcher - so klein zu halten, dass ein signifikanter Anteil (> 10%) des Gesamtstroms im Kathodenemitter von den Löchern getragen wird. Diesem Umstand ist es zu verdanken, dass zum Abschalten ein im Vergleich zu heutigen GTOs wesentlich kleinerer Anteil des Löcherstroms über das Gate gelenkt wird.

Durch die erfindungsgemässe Eigenschaft des Kathodenemitters kann also ein einstellbarer Anteil des Löcherstroms durch den Kathodenemitter extrahiert werden. Wie soeben bemerkt, wird hierdurch die Funktion des Gates wesentlich entlastet, so dass im normalen Betrieb weniger hohe Gateströme für das Abschalten benötigt werden. Ausserdem wird das Auftreten von Stromfilamenten erfolgreich verhindert. Neben den schon geschilderten Eigenschaften des erfindungsgemässen Kathodenemitters kommt als weiterer wesentlicher Punkt hier noch hinzu, dass der Kontakt zwischen Kathodenemitter und Kathodenmetall keine ohmsche Charakteristik hat. Wegen der vergleichsweise niedrigen Randkonzentration des Kathodenemitters von 10¹⁹ cm⁻³ oder weniger bildet sich bei der Metallisierung mit Aluminium eine sogenannte Schottkybarriere aus, welche dem Stromfluss einen deutlich erhöhten Widerstand entgegensetzt als ein ohmscher Kontakt. Der mit wachsendem Strom ansteigende Spannungsabfall am nichtlinearen Kontaktwiderstand vermindert die Emittervorwärtsspannung, so dass die Emission des Kathodenemitters weiter geschwächt wird. Die Wirkung dieses nichtlinearen Kontaktwiderstandes ist mit der Wirkung eines externen Emitterballastwiderstandes vergleichbar, dessen stabilisierende Wirkung auf die Stromdichteverteilung beim Abschalten bekannt ist. Nach einem bevorzugten Ausführungsbeispiel wird der Effekt des Ballastwiderstandes durch die Emittercharakteristik wesentlich verstärkt.

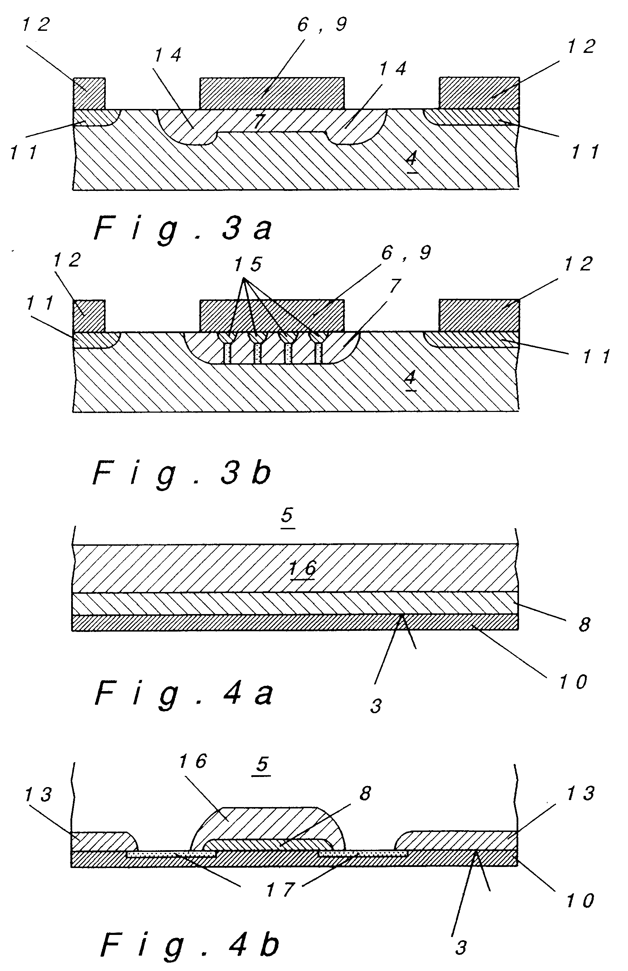

Wie die **Figuren 1 und 2** zeigen, kann der Anodenemitter (8) als durchgehende p+ dotierte Schicht (Figur 1) oder mit n+ dotierten Anodenkurzschlüssen durchsetzt ausgeführt sein (Figur 2). Beide Anodenstrukturen können weiterhin mit einer anodenseitigen Stopschicht (16) - in Figur 4a dargestellt - ausgeführt sein.

Der Kathodenemitter (7) kann ausserdem, wie in **Figur 3a** dargestellt wird, auch zweiteilig ausgeführt sein. Dabei weist der Emitter (7) an seinem Rand Gebiete (14) mit hoher Emissionseffizienz auf. Diese weisen eine Eindringtiefe von wenigen bis einige µm und eine Randkonzentration von mehr als 10¹⁹ cm⁻³ auf. Bei fingerförmigen Kathodenemittergebieten (7) stellen die Gebiete (14) mit hoher Emissionseffizienz also einen Ring dar, welcher die Finger vollständig umgibt. Diese Anordnung weist gegenüber derjenigen von Figur 1 verbesserte Zündeigenschaften auf. Die Gebiete (14) mit hoher Emissionseffizienz befinden sich nämlich in der Nähe des Gatekontaktes (11, 12). Beim Abschalten zieht das Gate im wesentlichen Ladungsträger unterhalb der Emitterränder (14) weg. Da das Emitterzentrum für einen grossen Anteil des Löcherstroms ohne Elektronenemission passiert werden kann, wirkt sich der Abschnüreffekt des Plasma nicht in der üblichen negativen Form aus. Dadurch erreicht man eine Erhöhung der abschaltbaren Ströme. Ausserdem besitzt die eben erläuterte Struktur wegen der Emitterränder (14) mit hoher Emissionseffizienz einen kleineren Durchlasswiderstand als die Struktur nach Figur 1. Anodenseitig können entweder ein durchgehender oder ein mit Kurzschlüssen (13) durchsetzter Anodenemitter (8) vorgesehen werden. Beide Anodenstrukturen können weiter mit einer anodenseitigen Stopschicht (16) wie in Figur 4a ausgeführt werden.

Dieses und ein weiteres Ausführungsbeispiel des Anodenemitters sind in den **Figuren 4a und 4b** dargestellt. Die anodenseitige, n+ dotierte, in die n-Basis (5) integrierte Stopschicht (16) ermöglicht die Ausbildung eines trapezförmigen Feldverlaufs im blockierenden Zustand und damit bei fester maximaler Blockierspannung die Verwendung eines dünneren Substrats. Als Folge davon können Durchlass- und Schaltverluste bei diesem Ausführungsbeispiel stark reduziert werden. Die Ladungsträgerextraktion kann weiter gesteigert werden, wenn in diesem Fall auch der Anodenemitter für einen grossen Anteil des Elektronenstroms ohne Löcherstrom passierbar ist. Wie beim Kathodenemitter kann diese Eigenschaft durch flache und niedrig dotierte Anodenemittergebiete erreicht werden.

Eine effiziente Ladungsträgerextraktion kann aber auch dadurch erreicht werden, dass zusätzlich zur Stopschicht (16) Anodenkurzschlüsse (13) vorgesehen sind. Aufgrund der hohen Leitfähigkeit (n+ dotiert) der Stopschicht (16) wird die Emissionsfähigkeit des p+ Emitters (8) aber stark eingeschränkt. Damit dennoch ein genügend grosser Spannungsabfall erreicht wird, muss zwischen Anodenmetallisierung (10) und Stopschicht (16) ein vergleichsweise hoher Widerstand entstehen. Deshalb sind in Figur 4b die Gebiete der n-Basis, welche bis zur anodenseitigen Hauptfläche (3) dringen, durch Isolationsgebiete (17) von der Anodenmetallisierung (10) isoliert.

Ein weiteres Konzept für die Strukturierung des transparenten Kathodenemitters (7) ist in **Figur 3b** dargestellt. Um die erfindungsgemässe Emittereigenschaft zu erhalten, sind für die Randkonzentrationen Werte < 10¹⁹ cm⁻³ (z.B. 10¹⁸ cm⁻³) und für die Eindringtiefe Bruchteile von µm einzustellen. Dadurch ergeben sich aber zwei Probleme: Zum ersten stellt sich bei einer Metallisierung eines derart niedrig dotierten n-Gebiets ein nicht linearer, hoher Kontaktwiderstand ein, welcher durch das Auftreten einer Schottky-Barriere hervorgerufen wird. Die weiter vorne beschriebenen positiven Eigenschaften dieser Barriere können bei sehr niedrigen Randkonzentrationen nicht mehr akzeptabel sein. Weitere Schwierigkeiten entstehen durch die Eindiffusion von Aluminium in das n-Gebiet mit der Gefahr des Durchlegierens und des dadurch verursachten Kursschlusses des n-Gebietes. Es wäre also wünschenswert, wenn die transparenten Emittergebiete (7) weiterhin Randkonzentrationen von mehr als 10¹⁹cm⁻³ und Eindringtiefen von mehr als 1 µm aufweisen würden.

Ein Kathodenemitter (7) im Sinne der Erfindung kann nun dennoch dadurch erreicht werden, dass in ein konventionelles Emitterprofil mit vergleichsweise hoher Emissionsfähigkeit eine Mehrzahl von Inseln (15), welche entgegengesetzt dotiert sind, eingelassen sind. Diese Inseln (15) dringen in eine Tiefe der Emitterschicht (7) vor, in der die Minoritätsträgerlebensdauer entsprechend der Dotierungshöhe noch relativ hoch ist. Entsprechend hoch ist dann auch die Minoritätsträgerdichte. Die Minoritätsträger verlassen den Emitter also über diese eindiffundierten Inseln (15). Dadurch wirken die Gebiete unterhalb der Inseln (15) (punktiert hervorgehoben) als Emittergebiete mit schwacher Elektronenemission. Dieses Konzept kann auch für eine Struktur nach Figur 3a verwendet werden, indem man im Randgebiet mit normal hoher Effizienz keine Inseln vorsieht.

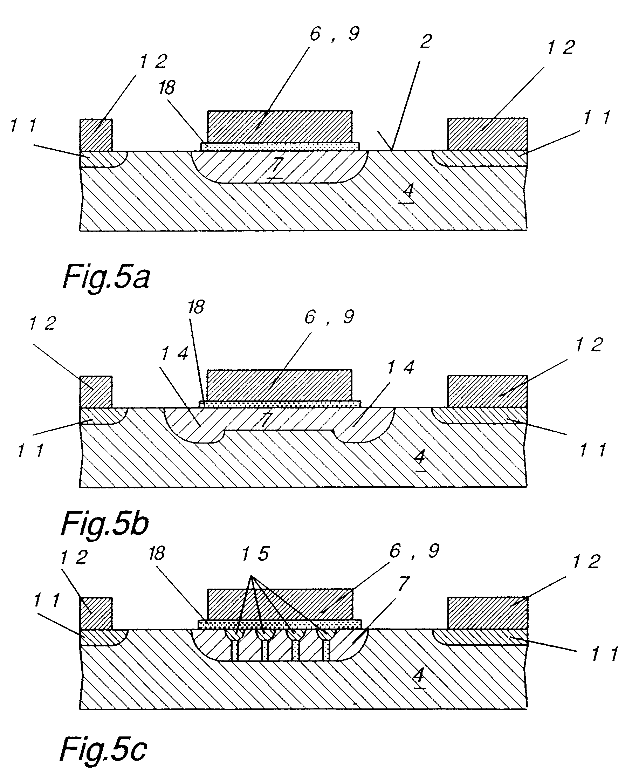

Weitere Ausführungsbeispiele des Kathodenemitters sind schliesslich in den **Figuren 5a-c** dargestellt. Um das oben erläuterte Durchlegieren bei sehr flachen Kathodenemittern (7) zu verhindern, kann zusätzlich zwischen der Metallisierung (9) und dem Kathodenemitter (7) eine Diffusionsbarrierenschicht (18) vorgesehen werden. Diese besteht z.B. aus aufgedampftem oder aufgesputtertem und anschliessend strukturiertem Wolfram-Titan. Eine andere Möglichkeit, das Durchlegieren des Aluminiums zu vermeiden, ist die Verwendung von bereits mit 1% Silizium gesättigtem Aluminium.

Allgemein können alle vorgestellten Kathodenkonzepte (Figuren 1, 3a, 3b, 5a-c) mit allen Anodenkonzepten (Figuren 2, 4a und 4b) kombiniert werden.

Mit der Erfindung erreicht man also den überraschenden Effekt, dass ein erfindungsgemässer Emitter entgegen der fachüblichen Meinung sogar bei GTOs vorteilhaft angewendet werden kann und insbesondere folgende Vorteile mit sich bringt:
- hohe Abschaltstromdichten,
- kleine Gateströme,
- geringer Beschaltungsaufwand,
- wenig statische und dynamische Verluste.

### Bezeichnungsliste

- 1: Leistungshalbleiter-Bauelement
- 2: Kathodenseitige Hauptfläche
- 3: Anodenseitige Hauptfläche
- 4: p-Basis
- 5: n-Basis
- 6: Kathode
- 7: Kathodenemittergebiete
- 8: Anodenemitter
- 9: Kathodenmetallisierung
- 10: Anodenmetallisierung
- 11: Gate-Gebiete
- 12: Gatemetallisierung
- 13: Anodenkurzschlussgebiet
- 14: Kathodenemittergebiete mit hoher Emissionseffizienz
- 15: p+ Kathodenemitterinseln
- 16: anodenseitige Stopschicht
- 17: Isolationsgebiete
- 18: Diffusionsbarrierenschicht

## Patentansprüche

1. Abschaltbares Leistungshalbleiterbauelement (1), umfassend
a) zwischen einer kathodenseitigen (2) und einer anodenseitigen (3) Hauptfläche ein Folge unterschiedlich dotierter Schichten, insbesondere von der kathodenseitigen Hauptfläche (2) her eine p-Basis (4), ein n-Basis (5) und einen p-Emitter (8);
b) eine Kathode (6), welche durch eine Vielzahl von in die p-Basis (4) eingelassenen und von einer Metallschicht (9) bedeckten n-Emittergebieten (7) gebildet wird;
dadurch gekennzeichnet, dass
c) die Kathodenemittergebiete (7) eine schwache Emissionseffizienz aufweisen, und
d) der Anteil der Minoritätsträger an einem durch das Leistungshalbleiterbauelement fliessenden Strom in den Kathodenemittergebieten (7) mehr als ca. 10% beträgt.

2. Leistungshalbleiterbauelement (1) nach Anspruch 1, dadurch gekennzeichnet, dass die Kathodenemittergebiete (7) an ihrem Rand von Gebieten (14) mit höherer Emissionseffizienz umgeben sind, und eine Eindringtiefe dieser Gebiete (14) ungefähr doppelt so hoch ist wie diejenige der Kathodenemittergebiete (7).

3. Leistungshalbleiterbauelement (1) nach Anspruch 1, dadurch gekennzeichnet, dass die Kathodenemittergebiete (7) mit Kathodenemitterinseln (15) des entgegengesetzten Dotierungstyps durchsetzt sind.

4. Leistungshalbleiterbauelement (1) nach Anspruch 1, 2 oder 3, dadurch gekennzeichnet, dass der p-Emitter (8) mit Anodenkurzschlussgebieten (13) durchsetzt ist.

5. Leistungshalbleiterbauelement (1) nach Anspruch 1, 2 oder 3, dadurch gekennzeichnet, dass zwischen der n-Basis (5) und dem Anodenemitter (8) eine n-dotierte Stopschicht (16) vorgesehen ist.

6. Leistungshalbleiterbauelement nach einem der Ansprüche 1, 2 oder 3, dadurch gekennzeichnet, dass
a) die Anodenemitter (8) als unterbrochene Gebiete ausgeführt sind, welche von einer n-dotierten Stopschicht (16) umgeben sind,
b) abwechselnd mit den Anodenemitter- (8) und Stopschichtgebieten (16) Anodenkurzschlussgebiete (13) vorgesehen sind,
c) die n-Basis (5) zwischen den die Anodenemittergebiete (8) umgebenden Stopschichtgebieten (16) und den Anodenkurzschlussgebieten (13) an die anodenseitige Hauptfläche (3) dringt; und
d) eine die anodenseitige Hauptfläche (3) bedeckende Metallisierung (10) in den Gebieten, wo die n-Basis (5) an die anodenseitige Hauptfläche (3) dringt durch Isolationsgebiete (17) unterbrochen ist.

7. Leistungshalbleiterbauelement (1) nach einem der Ansprüche 1-6, dadurch gekennzeichnet, dass zwischen der Metallschicht (9) und der kathodenseitigen Hauptfläche (2) eine Diffusionsbarrierenschicht (18) aufgebracht ist.

8. Leistungshalbleiterbauelement (1) nach Anspruch 7, dadurch gekennzeichnet, das die Diffusionsbarrierenschicht (18) aus Wolfram-Titan besteht, welches aufgedampft oder aufgesputtert wird.

9. Leistungshalbleiterbauelement (1) nach einem der Ansprüche 1-6, dadurch gekennzeichnet, dass als Kathodenmetallisierung (9) mit ca. 1% Silizium gesättigtes Aluminium verwendet wird.

10. Leistungshalbleiterbauelement (1) nach Anspruch 7 oder 9, dadurch gekennzeichnet, dass die Eindringtiefe der Kathodenemittergebiete (7) Bruchteile von µm beträgt, und die Kathodenemittergebiete (7) mit einer Trägerdichte von weniger als 10¹⁹ cm⁻³ dotiert sind.
